# FASCICULE DE BREVET EUROPEEN

(11) **EP 1 659 413 B1**
(45) Date de publication et mention de la délivrance du brevet: **06.04.2011**
(21) Numéro de dépôt: 04405726.3
(22) Date de dépôt: 23.11.2004
(51) Int. Cl.: G01R 15/14, H01F 27/34

(54) **Transformateur d'isolation**
Trenntransformator
Isolation transformer

(43) Date de publication de la demande: 24.05.2006
(73) Titulaire: LIAISONS ELECTRONIQUES-MECANIQUES LEM S.A., 1228 Plan-les-Ouates (CH)
(72) Inventeur: Gudel, Claude, 74160 Archamps (FR); Marquet, François, 01170 Crozet (FR)
(74) Mandataire: Reuteler, Raymond Werner

(56) Documents cités:
- GB-A- 2 307 795
- US-A- 4 172 244

## Description

La présente invention concerne une alimentation électrique pour des circuits ou des dispositifs électroniques disposés dans un environnement haute tension et nécessitant une isolation électrique, entre autres pour des raisons de sécurité. L'invention concerne notamment une alimentation pour un dispositif de mesure, notamment un capteur électrique, disposé dans un environnement haute tension.

Pour de nombreux systèmes électriques à haute tension, on souhaite mesurer le courant ou la tension à des fins de contrôle et de réglage. Une parmi les multiples applications est la mesure de valeurs électriques de lignes haute tension de réseaux ferroviaires, qui nécessitent des tensions d'isolation allant jusqu'à 12 kV.

Afin d'éviter des problèmes d'isolation électrique entre les côtés haute tension et basse tension, il est connu, pour certains capteurs de courant et de tension, de puiser l'énergie électrique dont ils ont besoin pour leur fonctionnement des lignes haute tension auxquelles ils sont couplés pour la mesure des valeurs électriques. Ceci est généralement possible si l'énergie électrique utilisée pour le fonctionnement du dispositif de mesure est faible par rapport à l'énergie électrique circulant dans les lignes haute tension à mesurer. Une telle alimentation est néanmoins difficile à mettre en oeuvre, et comporte certains désavantages. D'une part, le transformateur nécessaire pour soutirer de l'énergie électrique d'une ligne haute tension pour alimenter le dispositif électronique, ne pourrait être mis en oeuvre que si la fréquence du courant haute tension est connue et stable. D'autre part, il est avantageux de pouvoir disposer le dispositif de mesure dans différents systèmes à courant alternatif ou à courant direct, sans modifications importantes, et notamment sans devoir modifier son dispositif d'alimentation.

Un problème spécifique, dans le cas de mesure de tensions différentielles entre deux phases, est que l'on n'arrive pas à mesurer précisément le point "zéro", c'est-à-dire quand la différence de potentiel entre les deux phases est nulle, puisque le capteur n'est pas alimenté quand la tension différentielle est nulle.

Une autre solution consisterait à fournir l'énergie électrique pour le fonctionnement du dispositif électronique en puisant cette énergie du côté basse tension. Une telle alimentation permettrait d'éliminer ou réduire les inconvénients précités, mais nécessiterait alors de résoudre le problème de l'isolation électrique.

Dans des systèmes d'alimentation disposés entre un côté basse tension (secondaire) et un côté haute tension (primaire), il est connu d'insérer entre les côtés primaire et secondaire un dispositif isolateur, sous forme d'un transformateur à plusieurs circuits magnétiques, tel que décrit dans les publications GB-A-2307795 et US 4,172,244.

Dans GB-A-2307795, on décrit un transformateur isolateur avec deux ou trois circuits magnétiques, couplés entre eux par des bobines intermédiaires, du côté primaire à une bobine primaire, et du côté secondaire à une bobine secondaire. Dans US 4,172,244, on propose également de disposer un circuit magnétique intermédiaire entre les circuits magnétiques des côtés primaire et secondaire, dans le but de réaliser l'isolation électrique et de réduire les courants de fuite provoqués par le couplage capacitif.

Les mesures proposées pour la réduction du couplage capacitif comprennent l'insertion de blindages électriques autour des bobines et la réduction du nombre de spires des bobines intermédiaires couplant les circuits magnétiques entre eux.

En dépit des mesures proposées, dans les transformateurs isolateurs conventionnels, le couplage capacitif entre les côtés primaire et secondaire et les ondes électromagnétiques parasites générées restent trop élevés, notamment dans des applications où les changements de potentiels (dv/dt) peuvent être très élevés, ce qui peut être le cas par exemple du dv/dt en mode commun sur les lignes ferroviaires, qui peut atteindre jusqu'à 6 kV/µs. D'autre part, la résistance aux fuites électriques de surface (creep résistance) peut être insuffisante, et notamment si les feuilles diélectriques séparant les bobines et les circuits magnétique se détériorent avec le temps. Une construction classique de couches de bobine diélectriques, de blindages et de boîtier du dispositif isolateur est également relativement onéreuse à réaliser et peut subir des problèmes d'échauffement lors de son utilisation.

Au vu de ce qui précède, un but de l'invention est de fournir un système d'alimentation pour un circuit électronique disposé dans un environnement haute tension ayant une très bonne isolation électrique, un niveau faible de décharges partielles, une faible émission d'ondes électromagnétiques parasites et un couplage capacitif faible, même pour des dv/dt élevés en mode commun sur le côté haute tension.

Il est avantageux de fournir un système d'alimentation d'un dispositif électronique disposé dans un environnement haute tension, qui est compact, fiable et peu onéreux.

Il est avantageux de fournir un dispositif isolateur pour un système d'alimentation d'un circuit électronique disposé dans un environnement haute tension, ayant une très haute résistance à des fuites électriques de surface et une très haute tension de claquage.

Un autre but de l'invention est de fournir un dispositif de mesure de valeurs électriques de lignes haute tension qui est précis, fiable et qui peut subir de fortes variations de dv/dt en mode commun.

Il est avantageux de fournir un dispositif de mesure qui peut être utilisé pour la mesure de valeurs électriques de lignes haute tension, mais qui peut également être déployé facilement et sans modification importante dans différents environnements et pour différentes applications.

Il est avantageux de fournir un dispositif de mesure de valeurs électriques de lignes haute tension, ayant une très bonne isolation électrique, une faible émission d'ondes électromagnétiques parasites, un couplage capacitif faible avec le côté basse tension, une haute résistance à des fuites électriques de surface et une très haute tension de claquage.

Des buts de l'invention sont réalisés par un système selon la revendication 1.

Dans la présente invention, une alimentation électrique pour circuits disposés dans un environnement haute tension comprend un dispositif isolateur interconnectant le côté basse tension (côté secondaire) au côté haute tension (côté primaire) le dispositif isolateur comprenant un circuit magnétique côté primaire couplé au moyen d'une bobine primaire à une alimentation du circuit électronique dans l'environnement haute tension, un circuit magnétique côté secondaire couplé au moyen d'une bobine secondaire à une source de courant, et au moins un circuit magnétique intermédiaire entre les circuits magnétiques primaire et secondaire couplé à ces derniers au moyen de bobines intermédiaires, les bobines intermédiaires comprenant des parties de spires montées sur au moins une plaquette de circuit.

Les parties de spire sont de préférence sous forme de conducteurs en forme de "U". La ou les plaquettes de circuit comprennent de préférence des pistes conductrices pour interconnecter les conducteurs en "U" afin de fermer les spires des bobines intermédiaires.

De préférence, il y a au moins deux plaquettes de circuit, une du côté primaire et une du côté secondaire, séparées par un espace d'air ou un espace rempli d'une matière isolante, telle qu'une résine époxy, pour augmenter la résistance au claquage et la résistance aux fuites électriques de surface.

Les conducteurs en "U" des parties de spires des bobines intermédiaires du dispositif isolateur peuvent être formés par étampage et disposés de manière à être espacées du circuit magnétique par un espace correspondant à environ un quart du diamètre de l'ouverture formée par le circuit magnétique, ou plus. Ceci permet de réduire fortement le couplage capacitif entre les bobines et les circuits magnétiques.

Les bobines intermédiaires peuvent avantageusement former une boucle fermée essentiellement en forme de "8" pour annuler les champs magnétiques de fuites générées dans ces bobines.

De préférence, la source d'énergie électrique côté basse tension est une source de tension sinusoïdale stabilisée, afin d'éviter la génération de fréquences harmoniques élevées pouvant-perturber les signaux de mesure.

L'alimentation côté haute tension peut comprendre un circuit redresseur et filtre pour générer un courant direct sans composante fréquentielle.

Dans la présente, on décrit également un appareil de mesure de valeurs électriques de lignes haute tension comprenant un dispositif d'alimentation comme décrit auparavant, un capteur disposé côté haute tension et une unité de traitement disposée côté basse tension.

Le capteur peut comprendre un capteur de tension différentielle pour la mesure de tensions différentielles entre deux phases haute tension, ainsi qu'un convertisseur analogue digital pour la transmission des signaux de mesure à l'unité de traitement.

Le capteur peut en outre comprendre un oscillateur connecté au convertisseur analogue numérique et envoyant un signal de synchronisation à un convertisseur numérique analogique de l'unité de traitement en parallèle au signal numérique de mesure.

L'unité de traitement et le capteur peuvent communiquer au moyen de fibres optiques.

D'autres buts et aspects avantageux ressortiront des revendications dépendantes, de la description ci-après et des dessins annexés, dans lesquels:
La Fig. 1 est un schéma illustrant un appareil de mesure, en l'occurrence un appareil de mesure de tension différentielle pour des lignes haute tension, comprenant une alimentation électrique selon l'invention;
La Fig. 2 est une vue en coupe et en perspective de l'appareil de mesure de tension différentielle pour des lignes conductrices dans le domaine ferroviaire;
La Fig. 3a est une vue en perspective d'un dispositif isolateur de l'alimentation électrique selon l'invention;
La Fig. 3b est une vue plane du dessous des plaques de circuit du dispositif isolateur selon l'invention;
La Fig. 4 est une vue en perspective schématique illustrant le couplage des circuits magnétiques du dispositif isolateur par une bobine intermédiaire.

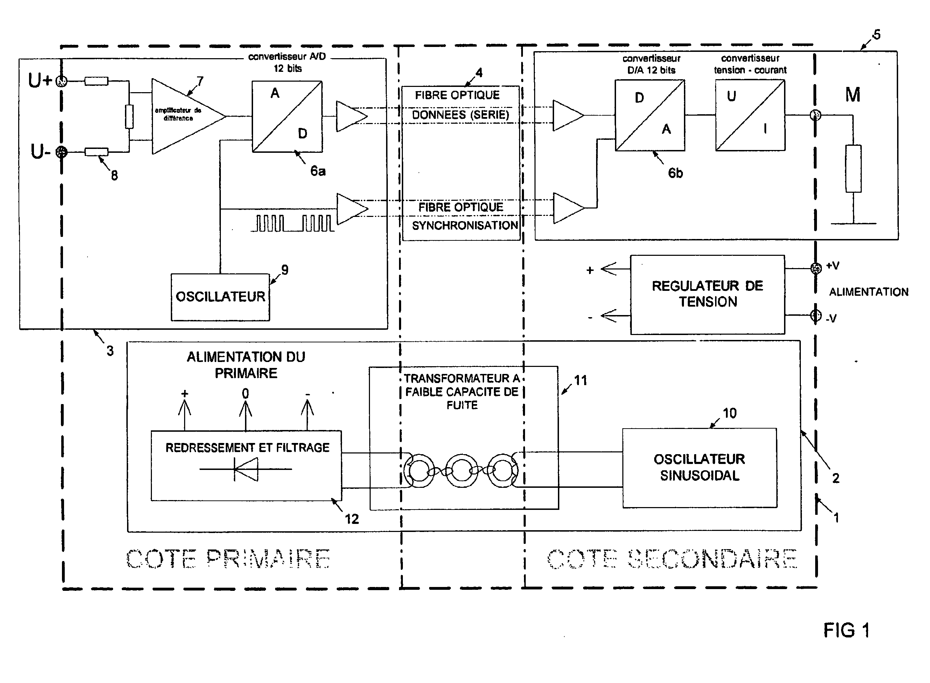

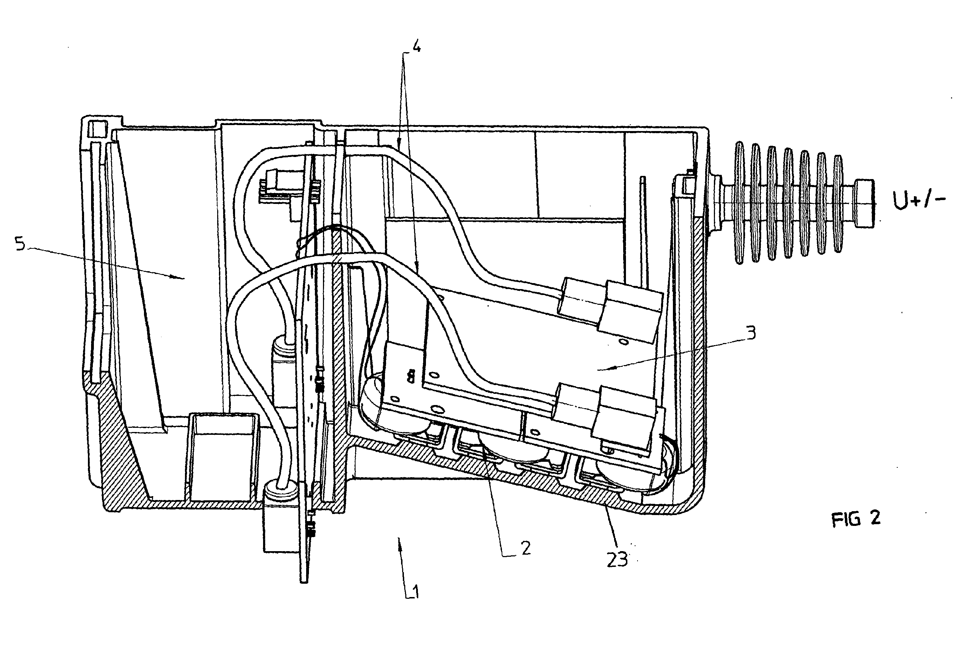

En faisant référence aux figures, notamment aux figures 1 et 2, un dispositif de mesure 1 de valeurs électriques comprend un système d'alimentation 2, une unité de traitement de signaux 5, et un capteur de tension différentielle 3 disposé dans un environnement haute tension (côté primaire) et apte à mesurer des valeurs électriques de lignes haute tension. Dans l'exemple montré, le capteur de tension mesure la tension différentielle entre deux phases des lignes haute tension de réseau ferroviaire avec des potentiels allant jusqu'à 6kV.

Le capteur transmet les signaux de mesure par une voie non-conductrice d'électricité, telle qu'une fibre optique 4, alternativement par ondes électromagnétiques, à l'unité de traitement des signaux 5 disposée du côté basse tension (côté secondaire). Le dispositif de mesure peut comprendre un boîtier 23 dans lequel sont montés l'alimentation et les circuits de traitement des signaux, le boîtier pouvant être rempli d'une résine après l'assemblage des composants (2, 3, 4, 5).

Le circuit électronique 3 du capteur peut comprendre un convertisseur analogique/numérique 6a afin de convertir les signaux de mesure analogiques, sortant d'un amplificateur différentiel 7 connecté à travers des impédances 8 aux bornes d'un capteur couplé aux deux phases, en signaux numériques pour leur transmission à l'unité de traitement de signaux 5. Pour la conversion des signaux numériques en signaux analogiques par le convertisseur numérique/analogique 6b de l'unité de traitement des signaux 5, un oscillateur 9 du capteur transmet un signal de synchronisation.

Le système d'alimentation 2 comprend une source de tension 10 du côté basse tension, de préférence une source de tension sinusoïdale stabilisée, couplée à travers un dispositif isolateur 11 à une unité d'alimentation 12 disposée du côté haute tension. L'unité d'alimentation est connectée au circuit électronique du capteur 3 pour son alimentation en courant électrique. L'unité d'alimentation 12 comprend un circuit de redressement et de filtrage afin de transformer le courant sinusoïdal d'entrée en un courant continu sans composante fréquentielle.

La source de courant sinusoïdal 10 a l'avantage, par rapport à des sources de courant commutées, d'éliminer ou de réduire des fréquences harmoniques élevées induites par les sources commutées, ceci afin de ne pas perturber le signal de mesure produit par le capteur 3 et traité par l'unité de traitement 5.

Le dispositif isolateur selon l'invention (voir notamment figures 1, 3a et 4) comprend au moins trois circuits magnétiques 13a, 13b, 13c, un circuit du côté primaire 13a, un circuit du côté secondaire 13c et un circuit intermédiaire 13b, les circuits étant de préférence sous forme d'éléments toriques en un matériau ayant une bonne perméabilité magnétique. Le dispositif isolateur comprend en outre une bobine primaire 14 connectée à l'unité d'alimentation primaire 12, une bobine secondaire 15 connectée à la source de tension 10 et des bobines intermédiaires 16, 17 montées sur des supports de circuit 18, 19 sous forme de circuits imprimés.

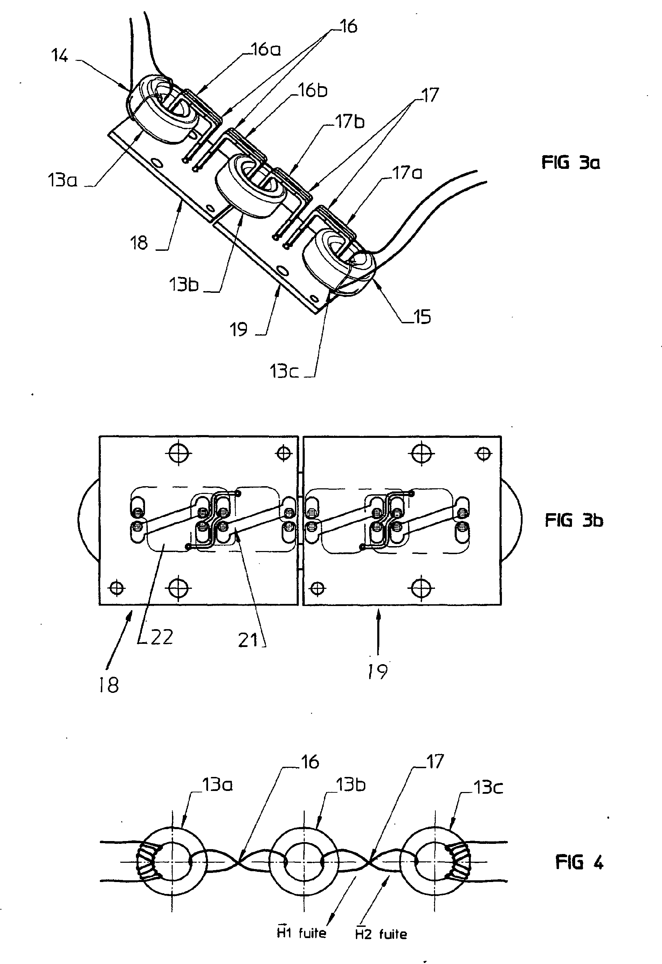

Les bobines intermédiaires comprennent des spires intermédiaires 16a, 16b, 17a, 17b formées en partie par des pièces métalliques de préférence étampées, en forme de U, montées sur les plaquettes de circuit 18, 19 et interconnectées électriquement par des pistes conductrices sur les plaquettes, de manière à former une boucle fermée essentiellement sous forme de "8", comme illustré dans la Fig. 4. Les pistes 21, 22 peuvent être disposées dans des couches différentes d'un circuit imprimé multicouches, afin de permettre leur croisement pour former la boucle en "8".

L'arrangement des spires intermédiaires en "U" sur un circuit imprimé, avec le positionnement des circuits magnétiques sur le circuit imprimé, permet de bien espacer les spires de circuit magnétique afin de réduire les couplages capacitifs, notamment entre les conducteurs des bobines intermédiaires 16, 17 et les circuits magnétiques. D'autre part, le faible nombre de spires des bobines intermédiaires permet également de réduire le couplage capacitif et de réaliser une bonne isolation galvanique.

Le croisement des spires intermédiaires 16a et 16b respectivement 17a et 17b, permet d'annuler les champs magnétiques de fuites H1, H2 (voir Fig. 4) générés par les demi-boucles de la bobine en forme de "8", et par conséquent de réduire les champs magnétiques parasites pouvant être émis par le dispositif isolateur.

Le montage des côtés primaire et secondaire sur des plaquettes de circuit 18, 19 (Fig. 3a) séparées augmente avantageusement la tension de claquage du dispositif et élimine les courants de fuite en surface, en raison de l'espace d'air, ou rempli d'une résine isolante, entre les plaquettes.

## Revendications

1. Alimentation électrique pour circuits électroniques disposés dans un environnement haute tension, comprenant un dispositif isolateur interconnectant le côté basse tension (côté secondaire) au côté haute tension (côté primaire), le dispositif isolateur comprenant un circuit magnétique (13a) côté primaire couplé au moyen d'une bobine primaire (14) à une alimentation (12) du circuit électronique dans l'environnement haute tension, un circuit magnétique (13c) côté secondaire couplé au moyen d'une bobine secondaire (15) à une source de courant (10) côté basse tension, et au moins un circuit magnétique intermédiaire (13b) entre les circuits magnétiques primaire et secondaire couplé à ces derniers au moyen de bobines intermédiaires, **caractérisée en ce que** les bobines intermédiaires (16, 17) comprennent des parties de spires montées sur au moins une plaquette de circuit (18, 19).

2. Alimentation électrique selon la revendication 1 **caractérisée en ce que** les parties de spires sont sous forme de conducteurs rigides en forme de "U".

3. Alimentation électrique selon la revendication 2, **caractérisée en ce que** les conducteurs en forme de "U" sont formés par étampage.

4. Alimentation électrique selon la revendication 2 ou 3 **caractérisée en ce que** la ou les plaquettes de circuit comprennent des pistes conductrices pour interconnecter les conducteurs en "U" afin de fermer les spires des bobines intermédiaires.

5. Alimentation électrique selon l'une quelconque des revendications précédentes, **caractérisée en ce qu'**il y a au moins deux plaquettes de circuit, une du côté primaire et une du côté secondaire, séparées par un espace.

6. Alimentation électrique selon l'une quelconque des revendications précédentes, **caractérisée en ce que** les parties de spires des bobines intermédiaires du dispositif isolateur, en forme de "U", sont formées et disposées de manière à être espacées du circuit magnétique par un espace correspondant à environ un quart du diamètre de l'ouverture formée par le circuit magnétique, ou plus.

7. Alimentation électrique selon l'une quelconque des revendications précédentes, **caractérisée en ce que** les bobines intermédiaires (16, 17) forment une boucle fermée essentiellement en forme de "8".

8. Alimentation électrique selon l'une quelconque des revendications précédentes, **caractérisée en ce que** la source de courant (10) côté basse tension est une source de tension sinusoïdale stabilisée.

9. Alimentation électrique selon l'une quelconque des revendications précédentes, **caractérisée en ce que** l'alimentation (12) côté haute tension comprend un circuit redresseur et filtre pour générer un courant direct sans composante fréquentielle.

10. Appareil de mesure de valeurs électriques de lignes haute tension, comprenant un dispositif d'alimentation selon l'une quelconque des revendications précédentes, un capteur (3) disposé côté haute tension et une unité de traitement (5) disposée côté basse tension.

11. Appareil selon la revendication 10, **caractérisé en ce que** l'unité de capteur comprend un capteur de tension différentielle pour la mesure de tensions différentielles entre deux phases haute tension, ainsi qu'un convertisseur analogue numérique pour la transmission des signaux de mesure à l'unité de traitement.

12. Appareil selon la revendication 11, **caractérisé en ce que** l'unité de capteur comprend un oscillateur (9) connecté au convertisseur analogue numérique et envoyant un signal de synchronisation à un convertisseur numérique analogique de l'unité de traitement en parallèle au signal numérique de mesure.

13. Appareil selon la revendication 11 ou 12, **caractérisé en ce que** l'unité de traitement (5) et l'unité de capteur (3) communiquent au moyen de fibres optiques.

## Claims

1. An electric power supply for electronic circuits positioned in a high voltage environment, comprising an insulating device interconnecting the low voltage side (secondary side) to the high voltage side (primary side), the insulating device comprising a magnetic circuit (13a) on the primary side coupled by means of a primary coil (14) to a power supply (12) of the electronic circuit in the high voltage environment, a magnetic circuit (13c) on the secondary side coupled by means of a secondary coil (15) to a current source (10) on the low voltage side, and at least one intermediate magnetic circuit (13b) between the primary and secondary magnetic circuits coupled to the latter by means of intermediate coils, **characterized in that** the intermediate coils (16, 17) comprise portions of turns mounted on at least one circuit board (18, 19).

2. The electric power supply according to claim 1, **characterized in that** the portions of turns are in the form of rigid U-shaped conductors.

3. The electric power supply according to claim 2, **characterized in that** the U-shaped conductors are formed by stamping.

4. The electric power supply according to claim 2 or 3, **characterized in that** the circuit board(s) comprise(s) conductive tracks for interconnecting the U-shaped conductors so as to close the turns of the intermediate coils.

5. The electric power supply according to any of the preceding claims, **characterized in that** there are at least two circuit boards, one on the primary side and one on the secondary side, separated by a gap.

6. The electric power supply according to any of the preceding claims, **characterized in that** the U-shaped portions of turns of the intermediate coils of the insulating device are formed and positioned so as to be spaced apart from the magnetic circuit by a gap corresponding to about one quarter of the diameter of the diameter of the aperture formed by the magnetic circuit, or more.

7. The electric power supply according to any of the preceding claims, **characterized in that** the intermediate coils (16, 17) form an essentially 8-shaped closed loop.

8. The electric power supply according to any of the preceding claims, **characterized in that** the current source (10) on the low voltage side is a stabilized sinusoidal voltage source.

9. The electric power supply according to any of the preceding claims, **characterized in that** the power supply (12) on the high voltage side comprises a rectifier and filter circuit for generating a direct current without any frequency component.

10. An apparatus for measuring electric values of high voltage lines, comprising a power supply device according to any of the preceding claims, a sensor (3) positioned on the high voltage side and a processing unit (5) positioned on the low voltage side.

11. The apparatus according to claim 10, **characterized in that** the sensor unit comprises a differential voltage sensor for measuring differential voltages between two high voltage phases, as well as an analogue/digital converter for transmitting measurement signals to the processing unit.

12. The apparatus according to claim 11, **characterized in that** the sensor unit comprises an oscillator (9) connected to the analogue/digital converter and sending a synchronization signal to a digital/analogue converter of the unit for processing the digital measurement signal in parallel.

13. The apparatus according to claim 11 or 12, **characterized in that** the processing unit (15) and the sensor unit (3) communicate by means of optical fibres.

## Patentansprüche

1. Elektrische Versorgung für elektronische Schaltkreise, die in einem Hochspannungsumfeld angeordnet sind, die eine Isoliervorrichtung umfasst, die die Niederspannungsseite (sekundäre Seite) mit der Hochspannungsseite (primäre Seite) zusammenschaltet, wobei die Isoliervorrichtung einen primärseitigen Magnetkreis (13a), der mit einer Primärspule (14) an eine Versorgung (12) des elektronischen Schaltkreises im Hochspannungsumfeld gekoppelt ist, einen sekundärseitigen Magnetkreis (13c), der mit einer Sekundärspule (15) an eine niederspannungsseitige Stromquelle (10) gekoppelt ist und mindestens einen Zwischenmagnetkreis (13b) zwischen dem primären und sekundären Magnetkreis, der an diese mit Hilfe von Zwischenspulen gekoppelt ist, umfasst, **dadurch gekennzeichnet, dass** die Zwischenspulen (16, 17) Windungsabschnitte umfassen, die auf mindestens einer Leiterplatte (18, 19) angebracht sind.

2. Elektrische Versorgung nach Anspruch 1, **dadurch gekennzeichnet, dass** die Windungsabschnitte starre Leiter in U-Form sind.

3. Elektrische Versorgung nach Anspruch 2, **dadurch gekennzeichnet, dass** die Leiter in U-Form durch Formschmieden geformt sind.

4. Elektrische Versorgung nach Anspruch 2 oder 3, **dadurch gekennzeichnet, dass** die Leiterplatte oder Leiterplatten Leitungsbahnen umfassen, um die U-förmigen Leiter zusammenzuschalten, um die Windungen der Zwischenspulen zu schließen.

5. Elektrische Versorgung nach einem der vorangehenden Ansprüche, **dadurch gekennzeichnet, dass** es mindestens zwei Leiterplatten gibt, eine auf der Primärseite und eine auf der Sekundärseite, die durch einen Raum getrennt sind.

6. Elektrische Versorgung nach einem der vorangehenden Ansprüche, **dadurch gekennzeichnet, dass** die Windungsabschnitte der Zwischenspulen der Isoliervorrichtung in U-Form derart geformt und angeordnet sind, dass sie vom Magnetkreis durch einen Raum beabstandet sind, der zirka einem Viertel des Durchmessers der Öffnung entspricht, die von dem Magnetkreis gebildet wird, oder mehr.

7. Elektrische Versorgung nach einem der vorangehenden Ansprüche, **dadurch gekennzeichnet, dass** die Zwischenspulen (16, 17) eine im Wesentlichen in Form einer 8 geschlossene Schleife bilden.

8. Elektrische Versorgung nach einem der vorangehenden Ansprüche, **dadurch gekennzeichnet, dass** die niederspannungsseitige Stromquelle (10) eine Quelle stabilisierter sinusförmiger Spannung ist.

9. Elektrische Versorgung nach einem der vorangehenden Ansprüche, **dadurch gekennzeichnet, dass** die hochspannungsseitige Versorgung (12) einen Gleichrichterkreis und Filter umfasst, um einen direkten Strom ohne Frequenzkomponente zu erzeugen.

10. Gerät zum Messen elektrischer Werte von Hochspannungsleitungen, das eine Versorgungsvorrichtung nach einem der vorangehenden Ansprüche, einen auf der Hochspannungsseite angeordneten Sensor (3) und eine Verarbeitungseinheit (5) umfasst, die auf der Niederspannungsseite angeordnet ist.

11. Gerät nach Anspruch 10, **dadurch gekennzeichnet, dass** die Sensoreinheit einen Differentialspannungssensor zum Messen von Differentialspannungen zwischen zwei Hochspannungsphasen umfasst, sowie einen Analog-Digital-Umformer für die Übertragung der Messsignale an die Verarbeitungseinheit.

12. Gerät nach Anspruch 11, **dadurch gekennzeichnet, dass** die Sensoreinheit einen Oszillator (9) umfasst, der an den Analog-Digital-Umformer gekoppelt ist und ein Synchronisationssignal an einen Digital-Analog-Umformer der Verarbeitungseinheit parallel zum digitalen Messsignal schickt.

13. Gerät nach Anspruch 11 oder 12, **dadurch gekennzeichnet, dass** die Verarbeitungseinheit (5) und die Sensoreinheit (3) mit Hilfe optischer Fasern kommunizieren.
